# EUROPÄISCHE PATENTSCHRIFT

(11) **EP 1 202 450 B1**
(45) Veröffentlichungstag und Bekanntmachung des Hinweises auf die Patenterteilung: **10.10.2007**
(21) Anmeldenummer: 01203562.2
(22) Anmeldetag: 20.09.2001
(51) Int. Cl.: H03H 7/01, H03H 5/00

(54) **Schaltungsanordnung**
Circuit arrangement
Arrangement de circuit

(30) Priorität: 23.09.2000 DE 10047214
(43) Veröffentlichungstag der Anmeldung: 02.05.2002
(73) Patentinhaber: NXP B.V., 5656 AG Eindhoven (NL)
(72) Erfinder: Wichern, Andreas, c/o Philips Corp Intel Prop GmbH, 52066 Aachen (DE)
(74) Vertreter: Volmer, Georg

(56) Entgegenhaltungen:
- EP-A- 0 596 721
- DE-A- 2 629 685
- DE-C- 588 591
- FR-A- 876 523
- FR-A- 2 020 307

## Beschreibung

Die Erfindung betrifft eine Schaltungsanordnung zum Filtern und/oder zum Selektieren einzelner Frequenzen oder Frequenzbereiche insbesondere von für mindestens eine integrierte Schaltung bestimmten und/oder von von mindestens einer integrierten Schaltung erzeugten Signalen, welche Schaltungsanordnung mindestens zwei elektrische Schwingkreise
- mit jeweils mindestens einem induktiven Element und
- mit jeweils mindestens einem kapazitiven Element aufweist.

In diesem Zusammenhang ist generell zu berücksichtigen, dass es beim Empfangen und/oder beim Generieren hochfrequenter Signale erforderlich ist, einzelne Frequenzen oder Frequenzbereiche aus einer Gesamtheit der empfangenen und/oder generierten Signale auszuwählen, das heißt zu selektieren. Diese Selektion wird üblicherweise mit induktive Elemente und kapazitive Elemente aufweisenden Filtern durchgeführt. Grundelement der Filtertechnologie sind mithin Resonanz- oder Schwingkreise, die im einfachsten Falle aus einer Spule (--> Induktivität L), deren Verluste sich mittels eines zur Spule parallelen Ersatzwiderstands Rₚ darstellen lassen, und aus einem parallel zur Spule geschalteten Kondensator (--> Kapazität C) bestehen. Der dynamische Bereich eines derartigen, mit Resonanzfrequenz fᵣ = (2π)⁻¹·(L·C)^{-0.5} schwingenden Schwingkreises aus passiven Elementen bei gegebener Versorgungsspannung und bei gegebenem Ansteuer-(wechsel)strom nimmt jedoch mit wachsendem Güte- oder Qualitätsfaktor Q normalerweise ab (der sogenannte Güte- oder Qualitätsfaktor Q ist ein Maß für die Filterwirkung und/oder für die Selektivität einer Schaltungsanordnung und wächst linear mit dem vorgenannten Widerstand R_{P}).

Diese Verringerung des dynamischen Bereichs ist insbesondere bei modernen Verfahren zur Herstellung von integrierten Schaltungen ein Problem, denn derartige signalempfangende, signalverarbeitende und/oder signalerzeugende Schaltungen müssen Signale im Niedrigspannungsbereich empfangen, verarbeiten und erzeugen können, um heutigen technischen Erfordernissen gerecht zu werden (man denke etwa an die Vielzahl elektrischer und elektronischer Geräte gerade auf dem Multimedia- oder auch auf dem Telekommunikationsgebiet).

In diesem Zusammenhang ist zu berücksichtigen, dass an die Betriebsdauer von in elektrische und elektronische Geräte implementierten Schaltungsanordnungen immer höhere Anforderungen gestellt werden, und zwar nicht zuletzt dann, wenn es sich um tragbare Geräte handelt. Hierbei ist die - in Zukunft wohl noch verstärkt zu beobachtende - Tendenz erkennbar, dass die Betriebsspannung von in derartigen Geräten eingesetzten integrierten Schaltkreisen (= ICs = integrated circuits) unter anderem auch aus thermischen Gründen immer weiter reduziert wird.

Um nun eine stärkere Filterwirkung zu erzielen, was bei der heutigen, ausgesprochen dichten Belegung der Frequenzbänder zum Unterdrücken von Störeinflüssen unbedingt erforderlich ist sowie im Falle der Generierung von Signalen der - nicht zuletzt auch oftmals amtlich geforderten - Eliminierung von unerwünschten Nebenprodukten dient, steigt in Anbetracht des vorstehend dargelegten linearen Zusammenhangs zwischen dem Güte- oder Qualitätsfaktor Q und dem zur Spule parallelen Ersatzwiderstand Rₚ dieser Ersatzwiderstandswert Rₚ zwangsläufig an (sofern alle weiteren Komponenten der Schaltungsanordnung unverändert bleiben).

Dieses Ansteigen des Ersatzwiderstandswerts R_{P}, findet seine praktische Grenze jedoch darin, dass sich bei gegebenem, durch eine aktive Schaltung erzeugtem festem Ansteuer(wechsel)strom sowie bei gegebener fester Betriebsspannung der dynamische Bereich der Schaltungsanordnung signifikant verkleinert, denn die durch den Ansteuer(wechsel)strom hervorgerufene Wechselspannung kann naturgemäß lediglich maximal das Doppelte der Betriebsspannung betragen; mit steigendem Ersatzwiderstandswert Rₚ wird diese Spannungsamplitude bereits bei immer geringeren Wechselströmen erreicht.

Hieraus resultiert, dass insbesondere, aber nicht nur bei akkumulatorgespeisten mobilen elektrischen und elektronischen Geräten, bei denen die Versorgungsspannungen immer geringer und gleichzeitig die Anforderungen an den dynamischen Bereich immer höher werden (betreffend beispielsweise den Empfang schwacher erwünschter Signale in Anwesenheit starker unerwünschter Signale), der Weg der kontinuierlichen Steigerung des Ersatzwiderstandswerts Rₚ zum Erhöhen des Güte- oder Qualitätsfaktors Q nicht zielführend, sondern vielmehr nachteilig ist; zudem ist die Größe des Ansteuer(wechsel)stroms häufig durch die Arbeitspunkteinstellung des Steuertransistors festgelegt, um etwa ein bestimmtes Kollektorstromrauschminimum zu erreichen oder um die für die Verarbeitung der Signale benötigte Transitfrequenz zu erzielen.

Eine Möglichkeit, den Güte- oder Qualitätsfaktor Q einer Schaltungsanordnung der eingangs genannten Art zu erhöhen, besteht nun konventionellerweise im Hinzufügen weiterer Windungen zum vorhandenen induktiven Element des Schaltkreises, denn in diesem Falle spielt auch die entstehende wechselseitige Gegeninduktivität zwischen den zusätzlichen Spulenwindungen eine Rolle.

Allerdings ist dieses Hinzufügen weiterer Windungen zum vorhandenen induktiven Element des Schaltkreises insofern nicht erfolgversprechend, als sich mathematisch zeigen läßt (vgl. H. H. Meinke/F. W. Gundlach: Taschenbuch der Hochfrequenztechnik; Springer-Verlag Berlin Heidelberg, 3. Auflage 1968, Seiten 183 ff, 185 ff), dass eine Steigerung des Güte- oder Qualitätsfaktors Q mittels einer Erhöhung der Windungsanzahl des induktiven Elements des Schaltkreises eine deutlich überproportionale Steigerung des die Verluste der Schaltungsanordnung repräsentierenden Ersatzwiderstandswerts Rₚ nach sich zieht (beispielsweise geht eine Verdoppelung der Windungsanzahl des induktiven Elements des Schaltkreises mit einer Verachtfachung des die Verluste der Schaltungsanordnung repräsentierenden Ersatzwiderstandswerts Rₚ einher); es wurde bereits weiter oben dargelegt, dass eine derartige Steigerung des äquivalenten Ersatzwiderstandswerts Rₚ ausgesprochen nachteilig ist (abgesehen davon dürfte die Kapazität des parallelen kapazitiven Elements dann nur noch ein Viertel der ursprünglichen Kapazität des kapazitiven Elements betragen).

Eine Schaltungsanordnung der eingangs genannten Art, bei der zumindest ein Teil der vorstehend dargelegten Schwierigkeiten berücksichtigt ist, ist durch die Druckschrift US 5 431 987 bekannt. Dort ist ein Rauschfilter mit einer ersten, als Induktanz wirkenden Spiralelektrode auf einem Isolatorsubstrat und mit einer zweiten, ebenfalls als Induktanz wirkenden Spiralelektrode über der ersten Spiralelektrode offenbart, wobei sich zwischen den beiden Spiralelektroden eine dielektrische Schicht befindet. Die beiden Induktanzen wirken durch ihre partielle Überlappung gleichzeitig als Kondensatoren, so dass zwischen den beiden Spiralelektroden eine Kapazität entsteht.

Zwar ermöglicht die bekannte Schaltungsanordnung in einer Signalübertragungsschaltung, in einer Stromversorgungsschaltung oder dergleichen eine akzeptable Rauschunterdrückung, jedoch erweist sich die Schaltungsanordnung gemäß der Druckschrift US 5 431 987 insofern als unvorteilhaft, als bei deren praktischer Realisierung eine gute, das heißt "feste" Kopplung der beiden Induktanzen (--> Kopplungsfaktor k zwischen den beiden Induktanzen nahe seinem Maximalwert 1) infolge der unterschiedlichen Ausbildung der zweiten Induktanz im Vergleich zur ersten Induktanz nicht realisierbar ist.

Des weiteren leidet bei der in der Druckschrift US 5 431 987 offenbarten Schaltungsanordnung der Güte- oder Qualitätsfaktor Q, der in diesem Falle linear mit der Wurzel aus dem Produkt der Induktivität L₁ der ersten Induktanz und der Induktivität L₂ der zweiten Induktanz anwächst (, das heißt Q direkt proportional zu (L₁· L₂)^{0,5}), darunter, dass die Induktivität L₁ der ersten Induktanz und die Induktivität L₂ der zweiten Induktanz aufgrund deren unterschiedlicher Ausbildung und aufgrund der Notwendigkeit eines flächenhaften Layouts verschieden groß sind, so dass der Güte- oder Qualitätsfaktor Q seinen Maximalwert nicht erreichen kann (bekanntlich wird (L₁·L₂)^{0,5} lediglich im Falle L₁ = L₂ maximal).

Des weiteren besteht bei der bekannten Schaltungsordnung das Problem, dass die beiden Induktanzen in unterschiedlichen und mithin verschiedenohmigen Metallierungslagen angeordnet sind, wodurch die Verluste deutlich erhöht werden und der Güte- oder Qualitätsfaktor Q signifikant herabgesetzt wird. Zudem ist die bekannte Schaltungsanordnung nicht in inhärent symmetrischer Anordnung realisierbar und demzufolge nur unzureichend einzeln mit der in integrierter Technik zu bevorzugenden differentiellen bzw. balancierten Schaltungstechnik kombinierbar (hierzu müßten die erste Induktanz und die zweite Induktanz jeweils paarweise eingesetzt werden, was in der Druckschrift US 5 431 987 nicht vorgesehen ist).

Der Erfindung liegt die Aufgabe zugrunde, eine Schaltungsanordnung der eingangs genannten Art bereitzustellen, die bei gegebener niedriger Versorgungsspannung einerseits einen den heutigen Anforderungen genügenden dynamischen Bereich ermöglicht sowie andererseits einen möglichst hohen Güte- oder Qualitätsfaktor Q aufweist; hierbei soll die Schaltungsanordnung in inhärent symmetrischer Anordnung realisierbar sowie mit der in integrierter Technik zu bevorzugenden differentiellen bzw. balancierten Schaltungstechnik kombinierbar sein.

Diese Aufgabe wird durch die im Anspruch 1 angegebenen Merkmale gelöst. Vorteilhafte Ausgestaltungen und zweckmäßige Weiterbildungen der vorliegenden Erfindung sind in den Unteransprüchen gekennzeichnet.

Gemäß der Lehre der vorliegenden Erfindung wird dadurch, dass die Schwingkreise und hierbei insbesondere die induktiven Elemente nicht etwa galvanisch, sondern (ausschliesslich) magnetisch fest miteinander gekoppelt sind, zum einen ein überraschend umfangreicher dynamischer Bereich ermöglicht und zum anderen ein hoher Güte- oder Qualitätsfaktor Q herbeigeführt. Dies ist darauf zurückzuführen, dass eine Steigerung des Güte- oder Qualitätsfaktors Q bei rein magnetischer Kopplung der Schwingkreise keineswegs eine überproportionale Steigerung, sondern lediglich eine direkt proportionale Steigerung des die Verluste der Schaltungsanordnung repräsentierenden Ersatzwiderstandswerts R_{P} nach sich zieht: Beispielsweise geht eine Verdoppelung des Güte- oder Qualitätsfaktors Q mit einer Verdoppelung des die Verluste der Schaltungsanordnung repräsentierenden äquivalenten Ersatzwiderstandswerts Rₚ einher.

Vor diesem Hintergrund besteht hinsichtlich des Designs und des Layouts der Schaltungsanordnung gemäß der vorliegenden Erfindung wesentlich mehr Spielraum als bei konventionellen Schaltungsanordnungen; so ist es etwa mit Vorteil möglich, die Anordnung von zwei Schwingkreisen mit magnetisch fester Kopplung (--> Kopplungsfaktor k zwischen den beiden induktiven Elementen nahe seinem Maximalwert 1) auf eine größere Anzahl von Schwingkreisen zu erweitern und mithin den Güte- oder Qualitätsfaktor Q weiter zu steigern.

Indem nun gemäß der Lehre der vorliegenden Erfindung zumindest ein Teil, vorzugsweise sämtliche Schwingkreise der Schaltungsanordnung an oder auf der integrierten Schaltung, insbesondere auf nur einer einen im wesentlichen konstanten Ohmschen Widerstand aufweisenden Metallisierungslage der integrierten Schaltung angeordnet sind, sind die zwei oder mehr induktiven Elemente nicht in unterschiedlichen und mithin verschiedenohmigen Metallierungslagen angeordnet; dies bedeutet insofern einen signifikanten Vorteil gegenüber konventionellen Schaltungsanordnungen, als die Schaltungsanordnung gemäß der vorliegenden Erfindung stets in der jeweils niedrigstohmigen, vorzugsweise obersten Metallisierungslage der integrierten Schaltung ausführbar ist; hierdurch können die beim Betrieb der Schaltungsanordnung auftretenden Verluste der Schwingkreise deutlich herabgesetzt werden, und der Güte- oder Qualitätsfaktor Q wird entscheidend vergrößert, was unter anderem auch darauf zurückzuführen ist, dass - bei konventionellen Schaltungsanordnungen notwendigerweise vorhandene - Kontakte zu weiteren, ohnehin höherohmigen Metallisierungslagen und daraus resultierende hohe zusätzliche Verluste bei der vorliegenden Erfindung vermieden werden.

In diesem Zusammenhang wird der Fachmann auf dem Gebiet der Schaltungstechnik besonders zu schätzen wissen, dass die Schaltungsanordnung gemäß der vorliegenden Erfindung in inhärent symmetrischer Anordnung realisierbar und demzufolge auch einzeln mit der in integrierter Technik zu bevorzugenden differentiellen bzw. balancierten Schaltungstechnik kombinierbar ist. Auch ist in bezug auf die vorliegende Schaltungsanordnung positiv zu bemerken, dass eine magnetisch feste Kopplung der Schwingkreise realisiert ist, was gegenüber in der Hochfrequenztechnik konventionellerweise gebräuchlichen Schaltungsanordnungen insofern einen erheblichen Fortschritt darstellt, als diese üblicherweise nur schwach gekoppelt sind (beispielsweise liegt der Kopplungsgrad bei sogenannten Bandpaßfiltern, die zwei miteinander gekoppelte Resonanzkreise aufweisen, häufig nur im Bereich von einigen wenigen Prozent).

Wenn die vorliegende Erfindung in besonders zweckmäßiger Weise weitergebildet werden soll, so empfiehlt es sich, dass mindestens zwei induktive Elemente jeweils eine, vorzugsweise jeweils mehrere zueinander in etwa konzentrische und/oder zueinander in etwa parallele Windungen aufweisen. Eine derartige Wicklungsanordnung ist beispielsweise dadurch realisierbar, dass ein induktives Element in Form einer mindestens eine Windung aufweisenden Spule innerhalb einer weiteren, ebenfalls mindestens eine Windung auf weisenden Spule angeordnet ist. Ein noch höherer Grad an magnetischer Kopplung ist erzielbar, wenn die jeweiligen Windungen von mindestens zwei induktiven Elementen in bevorzugter Ausgestaltung parallel zueinander gewickelt sind (in gewissem Sinne vergleichbar einer bifilaren Wicklung, bei der ebenfalls zwei oder mehr induktive Elemente ineinander verschlungen sind). Auf diese Weise wird eine möglichst enge Kopplung und damit eine größtmögliche Nähe der induktiven Elemente erreicht, was wiederum eine maximale magnetische Kopplung bewirkt.

Die Erfindung betrifft auch eine integrierte Schaltung, aufweisend mindestens eine Schaltungsanordnung der vorstehend beschriebenen Art.

Zwei Ausführungsbeispiele der vorliegenden Erfindung werden nachstehend anhand der Zeichnungen näher erläutert. Es zeigt:
Fig. 1 ein erstes Ausführungsbeispiel einer Schaltungsanordnung gemäß der vorliegenden Erfindung, in schematischer Aufsicht; und
Fig. 2 ein zweites Ausführungsbeispiel einer Schaltungsanordnung gemäß der vorliegenden Erfindung, in schematischer Aufsicht.

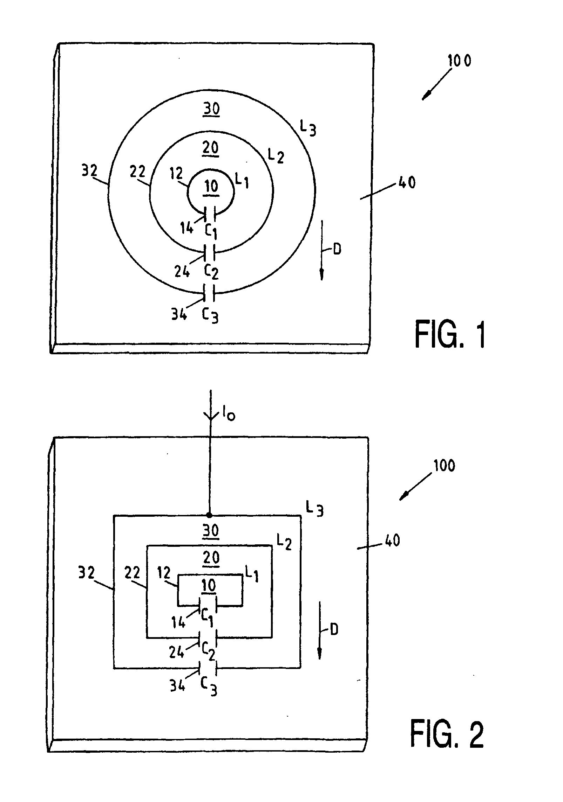

Die Schaltungsanordnung 100 ist zum Filtern und zum Selektieren einzelner Frequenzen oder Frequenzbereiche von Signalen vorgesehen, die für eine sich in den Figuren 1 und 2 jeweils unten anschließende (, in den Figuren 1 und 2 aus Gründen der Übersichtlichkeit der Darstellung nicht gezeigte) integrierte Schaltung bestimmt sind bzw. die von dieser integrierten Schaltung erzeugt werden.

Die Schaltungsanordnung 100 weist in beiden Ausführungsbeispielen jeweils drei elektrische Schwingkreise 10, 20, 30 auf, von denen jeder jeweils mit einem induktiven Element 12, 22, 32 in Form einer einzigen, im wesentlichen kreisrunden (vgl. Figur 1) oder rechteckigen (vgl. Figur 2) Windung und mit einem kapazitiven Element 14, 24, 34 in Form eines Kondensators ausgestattet ist; das kapazitive Element 14, 24, 34 ist an den Enden der jeweils einzigen Windung angeordnet.

Hierbei können die Kapazitäten C₁, C₂, C₃ der kapazitiven Elemente 14, 24, 34 gleich groß sein; dies muß jedoch nicht der Fall sein, denn durch geeignete Wahl der Kapazitäten C₁, C₂, C₃ der kapazitiven Elemente 14, 24, 34 kann unter anderem die Tatsache der unterschiedlichen Größen der induktiven Elemente 12, 22, 32 und der daraus resultierenden unterschiedlichen Induktivitäten L₁, L₂, L₃ in adäquater Weise kompensiert werden.

Die Besonderheit der anhand der Figuren 1 und 2 veranschaulichten Schaltungsanordnungen 100 ist nunmehr darin zu sehen, dass die Schwingkreise 10, 20, 30 und hierbei insbesondere die induktiven Elemente 12, 22, 32 nicht etwa galvanisch, sondern (ausschließlich) magnetisch fest miteinander gekoppelt sind, was sowohl dem dynamischen Bereich der Schwingkreise 10, 20, 30 als auch dem Güte- oder Qualitätsfaktor Q der Schaltungsanordnung 100 zugute kommt; dies ist insofern umso bemerkenswerter, als bei konventionellen Schaltungsanordnungen (vgl. etwa die Druckschrift US 5 431 987) eine Erhöhung des Güte- oder Qualitätsfaktors Q mit einer Erniedrigung des dynamischen Bereichs "erkauft" werden muß.

Im Gegensatz hierzu wird bei der vorliegenden Erfindung der dynamische Bereich infolge der rein magnetischen Kopplung der Schwingkreise 10, 20, 30 durch die Erhöhung des Güte- oder Qualitätsfaktors Q nicht beeinträchtigt. In diesem Zusammenhang wirkt auch begünstigend, dass die kapazitiven Elemente 14, 24, 34 in im wesentlichen einer Richtung D hintereinander angeordnet sind.

Um bei den beiden in den Figuren 1 und 2 dargestellten Ausführungsbeispielen das Prinzip der sogenannten "on-chip"-Filterung bzw. der sogenannten "on-chip"-Selektierung zu verwirklichen, sind die Schwingkreise 10, 20, 30 der Schaltungsanordnung 100 auf der obersten, einen im wesentlichen konstanten und ausgesprochen niedrigen Ohmschen Widerstand aufweisenden Metallisierungslage 40 der integrierten Schaltung gewissermaßen "on-chip" angeordnet. Hierzu sind die einzelnen Schwingkreise 10, 20, 30 im wesentlichen planar auf einer Außenfläche der integrierten Schaltung angeordnet, wobei die flache Ausbildung nicht zuletzt durch die im wesentlichen konzentrische geometrische Struktur (vgl. Figur 1: Kreise; vgl. Figur 2: Rechtecke) mit jeweils einer Windung als induktivem Element 12, 22, 32 und mit jeweils einem Kondensator als kapazitivem Element 14, 24, 34 verwirklicht ist.

Diese "on-chip"-Ausgestaltung der Schaltungsanordnung 100 mittels beispielsweise auf einem Halbleiterkristall integrierter Spulen 12, 22, 32 und Kondensatoren 14, 24, 34 dient nicht zuletzt auch der Einsparung externer Bauteile sowie der Reduzierung des Flächenbedarfs auf der Platine und vereinfacht auf diese Weise die Anwendung der integrierten Schaltung (= IC = integrated circuit) auch für technisch nicht sehr erfahrene Benutzer.

Dies ist besonders lohnend unter dem Gesichtspunkt von IC-Fertigungsprozessen, bei denen kein Substrat mehr vorhanden ist (sogenannte "silicon-on-insulator"-Prozesse (= "SOI-Prozesse") oder auch sogenannte "silicon-on-anything"-Prozesse (= "SOA-Prozesse"); vgl. etwa den sogenannten SPIRIT-Prozeß der Firma Philips), denn die dielektrischen Verluste des Substrats beeinträchtigen dann die sich im Güte- oder Qualitätsfaktor Q manifestierende Filterwirkung bzw. Selektivität der integrierten Resonanzkreise nicht mehr; aber auch in anderen Prozessen, wie etwa bei der QUBIC-Technologie, finden sich gezielte Anwendungsmöglichkeiten.

Über eine "Anzapfung" in der Mitte des in Figur 2 gezeigten induktiven Elements 32, das heißt im virtuellen Masse- oder Symmetriepunkt des Resonanzkreises aus induktivem Element 32 und kapazitivem Element 34 kann der an die Schaltungsanordnung 100 über die Enden des induktiven Elements 32 parallel zum kapazitiven Element 34 angeschlossenen aktiven integrierten Schaltung (vgl. die Figuren 1 und 2 jeweils unten; im Falle der "Mittelanzapfung" gemäß Figur 2 liegt dann eine differentielle Schaltung vor) dann sogar Gleichstrom I₀ für Biasingzwecke zugeführt werden, ohne dass eine Leiterkreuzung notwendig wäre und ohne dass eine Verbindung zur Mitte der Schaltungsanordnung 100 unbedingt erforderlich wäre. Eine entsprechende "Mittelanzapfung" ist auch für die Schaltungsanordnung 100 gemäß Figur 1 realisierbar.

Die vorliegende Schaltungsanordnung 100 gemäß den Figuren 1 und 2 kann beim selektiven Signalempfang und/oder bei der selektiven Signalabgabe für prinzipiell jede signalerzeugende und/oder signalverarbeitende integrierte Schaltung eingesetzt werden und zeichnet sich dadurch aus, dass sie extrem klein baut und somit einen substantiellen Beitrag bei der Verwirklichung des Ziels einer Miniaturisierung elektrischer und elektronischer Bauteile leistet.

Im speziellen ist die vorliegende Schaltungsanordnung 100 gemäß den Figuren 1 und 2 in Kombination mit einer Vielzahl von denkbaren integrierten Schaltungsfamilien (etwa auf Basis von GaAs = Galliumarsenid; MOS = metal-oxide-semiconductor; Si = Silizium; ...) realisierbar; Anwendungen sind hierbei für jedwede Schaltungsstruktur vorstellbar, bei der das Filtern und/oder das Selektieren mithilfe schwingender Resonanzkreise eine Rolle spielt, wie beispielsweise ein low-noise-amplifier, ein Mischer, ein spannungsgesteuerter Oszillator (mit Kapazitätsdioden); aber auch eine technische Realisierung als Einzelkomponente in einem Filter ist ohne weiteres möglich.

### BEZUGSZEICHENLISTE

- 100: Schaltungsanordnung
- 10: (erster) Schaltkreis
- 12: (erstes) induktives Element
- 14: (erstes) kapazitives Element
- 20: (zweiter) Schaltkreis
- 22: (zweites) induktives Element
- 24: (zweites) kapazitives Element
- 30: (dritter) Schaltkreis
- 32: (drittes) induktives Element
- 34: (drittes) kapazitives Element
- 40: Metallisierungslage
- C: Kapazität eines kapazitiven Elements
- C₁: Kapazität des (ersten) kapazitiven Elements 14
- C₂: Kapazität des (zweiten) kapazitiven Elements 24
- C₃: Kapazität des (dritten) kapazitiven Elements 34
- D: Anordnungsrichtung der kapazitiven Elemente 14, 24, 34
- fᵣ: Resonanzfrequenz
- I₀: Gleichstrom
- k: Kopplungsfaktor
- L: Induktivität eines induktiven Elements
- L₁: Induktivität des (ersten) induktiven Elements 12
- L₂: Induktivität des (zweiten) induktiven Elements 22
- L₃: Induktivität des (dritten) induktiven Elements 32
- Rₚ: paralleler Ersatzwiderstand
- Q: Güte- oder Qualitätsfaktor

## Patentansprüche

1. Schaltungsanordnung zum Filtern und/oder zum Selektieren einzelner Frequenzen oder Frequenzbereiche insbesondere von für mindestens eine integrierte Schaltung bestimmten und/oder von von mindestens einer integrierten Schaltung erzeugten Signalen, welche Schaltungsanordnung (100) mindestens zwei elektrische Schwingkreise (10; 20; 30)
- mit jeweils mindestens einem induktiven Element (12; 22; 32) und
- mit jeweils mindestens einem kapazitiven Element (14; 24; 34) aufweist,
**dadurch gekennzeichnet, dass** der Kopplungsfaktor zwischen den beiden Induktivitäten der induktiven Elemente (12; 22; 32) nahe Eins ist und
dass zumindest ein Teil, vorzugsweise sämtliche Schwingkreise (10; 20; 30) der Schaltungsanordnung (100) an oder auf der integrierten Schaltung, insbesondere auf nur einer einen im wesentlichen konstanten Ohmschen Widerstand aufweisenden Metallisierungsvorlage (40) der integrierten Schaltung angeordnet ist.

2. Schaltungsanordnung gemäß Anspruch 1,
**dadurch gekennzeichnet,**
**dass** das induktive Element (12; 22; 32) durch mindestens eine eine Induktivität (L₁; L₂;L₃) aufweisende Spule und/oder
**dass** das kapazitive Element (14; 24; 34) durch mindestens einen eine Kapazität (C₁; C₂; C₃) aufweisenden Kondensator gebildet ist.

3. Schaltungsanordnung gemäß Anspruch 1 oder 2,
**dadurch gekennzeichnet,**
**dass** die einzelnen Schwingkreise (10; 20; 30) im wesentlichen planar auf einer Außenseite, insbesondere auf einer Außenfläche, der integrierten Schaltung angeordnet sind.

4. Schaltungsanordnung gemäß mindestens einem der Ansprüche 1 bis 3,
**dadurch gekennzeichnet,**
**dass** die einzelnen Schwingkreise (10; 20; 30) durch im wesentlichen konzentrische geometrische Strukturen mit jeweils mindestens einer Windung als induktivem Element (12; 22; 32) und mit jeweils einem Kondensator als kapazitivem Element (14; 24; 34) ausgebildet sind.

5. Schaltungsanordnung gemäß Anspruch 4,
**dadurch gekennzeichnet,**
**dass** die geometrische Struktur ein Kreis, ein Oval, eine Ellipse, ein Quadrat, ein Rechteck oder dergleichen ist.

6. Schaltungsanordnung gemäß Anspruch 4 oder 5,
**dadurch gekennzeichnet,**
**dass** das kapazitive Element (14; 24; 34) an den Enden einer einzigen Windung angeordnet ist.

7. Schaltungsanordnung gemäß mindestens einem der Ansprüche 1 bis 6,
**dadurch gekennzeichnet,**
**dass** mindestens zwei induktive Elemente (12; 22; 32) jeweils eine, vorzugsweise jeweils mehrere zueinander in etwa konzentrische und/oder zueinander in etwa parallele Windungen aufweisen.

8. Schaltungsanordnung gemäß mindestens einem der Ansprüche 1 bis 7,
**dadurch gekennzeichnet,**
**dass** die kapazitiven Elemente (14; 24; 34) in im wesentlichen einer Richtung (D) hintereinander angeordnet sind.

9. Schaltungsanordnung gemäß mindestens einem der Ansprüche 1 bis 8,
**dadurch gekennzeichnet,**
**dass** mehr als zwei Schwingkreise (10; 20; 30) magnetisch fest miteinander gekoppelt sind.

10. Schaltungsanordnung gemäß mindestens einem der Ansprüche 1 bis 9,
**dadurch gekennzeichnet,**
**dass** die Schwingkreise (10; 20; 30) der Schaltungsanordnung (100) auf der obersten Metallisierungslage (40) der integrierten Schaltung angeordnet sind.

11. Integrierte Schaltung, aufweisend mindestens eine Schaltungsanordnung (100) gemäß mindestens einem der Ansprüche 1 bis 10.

## Claims

1. A circuit arrangement for filtering and/or selecting single frequencies or frequency ranges, in particular of signals intended for at least an integrated circuit and/or signals generated by at least an integrated circuit, said circuit arrangement (100) comprising at least two electric resonant circuits (10; 20; 30)
- each with at least an inductive element (12; 22; 32) and
- each with at least a capacitive element (14; 24; 34),
**characterized in that** the coupling factor between the two inductances of the inductive elements (12; 22; 32) is close to a value of one, and **in that** at least part of the, preferably all of the resonant circuits (10; 20; 30) of the circuit arrangement (100) are arranged at or on the integrated circuit, particularly on only one metallization plate (40) of the integrated circuit that has an essentially constant ohmic resistance.

2. A circuit arrangement as claimed in claim 1, **characterized in that** the inductive element (12; 22; 32) is constituted by at least a coil having an inductance (L₁; L₂; L₃) and/or in that the capacitive element (14; 24; 34) is constituted by at least a capacitor having a capacitance (C₁; C₂; C₃).

3. A circuit arrangement as claimed in claim 1 or 2, **characterized in that** the individual resonant circuits (10; 20; 30) are essentially arranged in a planar manner on an outer side, particularly on an outer surface area, of the integrated circuit.

4. A circuit arrangement as claimed in any one of claims 1 to 3, **characterized in that** the individual resonant circuits (10; 20; 30) are constituted by essentially concentric geometric structures, each having at least one turn as an inductive element (12; 22; 32) and each having a capacitor as a capacitive element (14; 24; 34).

5. A circuit arrangement as claimed in claim 4, **characterized in that** the geometric structure is a circle, an oval, an ellipse, a square, a rectangle, or the like.

6. A circuit arrangement as claimed in claim 4 or 5, **characterized in that** the capacitive element (14; 24; 34) is arranged at the ends of a single turn.

7. A circuit arrangement as claimed in any one of claims 1 to 6, **characterized in that** at least two inductive elements (12; 22; 32) each comprise one, preferably a plurality of turns which are substantially concentric and/or substantially parallel to each other.

8. A circuit arrangement as claimed in any one of claims 1 to 7, **characterized in that** the capacitive elements (14; 24; 34) are arranged one after the other in essentially one direction (D).

9. A circuit arrangement as claimed in any one of claims 1 to 8, **characterized in that** more than two resonant circuits (10; 20; 30) are magnetically fixedly coupled to each other.

10. A circuit arrangement as claimed in any one of claims 1 to 9, **characterized in that** the resonant circuits (10; 20; 30) of the circuit arrangement (100) are arranged on the upper metallization plate (40) of the integrated circuit.

11. An integrated circuit comprising at least a circuit arrangement (100) as claimed in any one of claims 1 to 10.

## Revendications

1. Système de circuit pour le filtrage et/ou pour la sélection de fréquences isolées ou de plages de fréquences, en particulier de signaux déterminés pour au moins un circuit intégré et/ou de signaux générés par au moins un circuit intégré, lequel système de circuit (100) comporte au moins deux circuits oscillants (10 ; 20 ; 30) électriques
- comportant chacun au moins un élément inductif (12 ; 22 ; 32) et
- comportant chacun au moins un élément capacitif (14 ; 24; 34),
**caractérisé en ce que**
le coefficient de couplage entre les deux inductances des éléments inductifs (12 ; 22 ; 32) est proche de un et **en ce qu'**au moins une partie, de préférence tous les circuits oscillants (10; 20 ; 30) du système de circuit (100) sont agencés contre ou sur le circuit intégré, en particulier uniquement sur une couche de métallisation (40), à résistance ohmique sensiblement constante, du circuit intégré.

2. Système de circuit selon la revendication 1,
**caractérisé en ce que**
l'élément inductif (12 ; 22 ; 32) est formé par au moins une bobine ayant une inductance (L₁ , L₂ ; L₃) et/ou **en ce que** l'élément capacitif (14 ; 24 ; 34) est formé par au moins un condensateur ayant une capacité (C₁; C₂ ; C₃).

3. Système de circuit selon la revendication 1 ou 2,
**caractérisé en ce que**
les différents circuits oscillants (10 ; 20 ; 30) sont agencés sensiblement de manière plane sur un côté extérieur, en particulier sur une surface extérieure, du circuit intégré.

4. Système de circuit selon l'une quelconque des revendications 1 à 3,
**caractérisé en ce que**
les différents circuits oscillants (10; 20; 30) sont formés par des structures géométriques sensiblement concentriques comportant chacune au moins un enroulement sous la forme d'un élément inductif (12 ; 22; 32) et chacune au moins un condensateur sous la forme d'un élément capacitif (14 ; 24; 34).

5. Système de circuit selon la revendication 4,
**caractérisé en ce que**
la structure géométrique est un cercle, un ovale, une ellipse, un carré, un rectangle ou similaire.

6. Système de circuit selon la revendication 4 ou 5,
**caractérisé en ce que**
l'élément capacitif (14 ; 24 ; 34) est agencé aux extrémités d'un seul enroulement.

7. Système de circuit selon l'une quelconque des revendications 1 à 6,
**caractérisé en ce que**
au moins deux éléments inductifs (12; 22; 32) comportent chacun un enroulement, de préférence chacun plusieurs enroulements sensiblement concentriques entre eux et/ou sensiblement parallèles entre eux.

8. Système de circuit selon l'une quelconque des revendications 1 à 7,
**caractérisé en ce que**
les éléments capacitifs (14; 24 ; 34) sont agencés les uns derrière les autres sensiblement dans une direction (D).

9. Système de circuit selon l'une quelconque des revendications 1 à 8,
**caractérisé en ce que**
plus de deux circuits oscillants (10 ; 20 ; 30) sont couplés magnétiquement de manière fixe les uns aux autres.

10. Système de circuit selon l'une quelconque des revendications 1 à 9,
**caractérisé en ce que**
les circuits oscillants (10; 20 ; 30) du système de circuit (100) sont agencés sur la couche de métallisation (40) supérieure du circuit intégré.

11. Circuit intégré comportant au moins un système de circuit (100) selon au moins l'une des revendications 1 à 10.
